# EUROPÄISCHE PATENTSCHRIFT

(11) **EP 1 145 269 B1**
(45) Veröffentlichungstag und Bekanntmachung des Hinweises auf die Patenterteilung: **21.07.2004**
(21) Anmeldenummer: 99915636.7
(22) Anmeldetag: 17.03.1999
(51) Int. Cl.: H01J 27/04

(54) **VERFAHREN ZUR ERZEUGUNG EINES GEPULSTEN ELEKTRONENSTRAHLS UND TRIGGERPLASMAQUELLE ZUR DURCHFÜHRUNG DES VERFAHRENS**
METHOD FOR GENERATING A PULSED ELECTRON BEAM AND A TRIGGER PLASMA SOURCE FOR CARRYING OUT SAID METHOD
PROCEDE POUR PRODUIRE UN FAISCEAU ELECTRONIQUE PULSE ET SOURCE DE PLASMA D'EXCITATION POUR METTRE EN OEUVRE LEDIT PROCEDE

(30) Priorität: 27.03.1998 DE 19813589
(43) Veröffentlichungstag der Anmeldung: 17.10.2001
(73) Patentinhaber: Forschungszentrum Karlsruhe GmbH, 76133 Karlsruhe (DE)
(72) Erfinder: FREY, Wolfgang, D-76137 Karlsruhe (DE)
(74) Vertreter: Rückert, Friedrich, Dr.
(86) Internationale Anmeldenummer: PCT/EP1999/001742
(87) Internationale Veröffentlichungsnummer: WO 1999/050878

(56) Entgegenhaltungen:
- EP-A- 0 464 383
- DE-A- 4 208 764
- FR-A- 2 498 010

## Beschreibung

Die Erfindung betrifft ein Verfahren zum Erzeugen eines gepulsten Elektronenstrahls und eine Triggerplasmaquelle zur Durchführung des Verfahrens.

Zur Herstellung dünner Schichten wird ein Elektronenstrahl auf ein Targetmaterial gerichtet, das aus dem gewünschten Schichtmaterial besteht. An der Auftreffstelle des Elektronenstrahls wird Targetmaterial in Form kleinster Tröpfchen abgetragen, das unter dem Begriff "Elektronenstrahlablation" in der Fachwelt bekannt ist. Das ablatierte Material schlägt sich auf einem exponierten Substrat in Form einer dünnen Schicht nieder.

Als Triggerplasmaquelle wird vorteilhafterweise die sehr stromstarke Kanalfunken-Entladung eingesetzt (Siehe DE 42 08 764). Prinzipiell wäre auch eine Pseudofunkenstrecke dazu geeignet, sie ist aber nicht so stromstark zu betreiben (siehe z. B. IEEE Transactions on PlasmaScience, Vol. 23, No. 3, June 1995 "Trigger Devices for Pseudospark Switches" von Th. Mehr et al.).

Die Elektronenstrahlquelle mit dem Prinzip der Kanalfunken-Entladung besteht im wesentlichen aus einer Plasmaquelle, einem davon wegführenden dielektrischen Rohr und einem Prozeßraum, in dem das dielektrische Rohr endet. Aus dem Plasma werden Elektronen, oder allgemeiner elektrische Ladungsträger, durch das Rohr hindurch in den Prozeßraum beschleunigt, die sich dort selbstbündeln (siehe Kanalfunke DE 42 08 764). Hierzu wird eine Elektrodengeometrie entsprechend mit elektrischen Potentialen belegt. Die Plasmaquelle wird auch Triggerplasmaquelle genannt. Im Prozeßraum schießt der extrahierte Elektronenstrahl auf ein Target und verdampft Targetmaterial, das sich dann teilweise auf einem dort exponierten Substrat niederschlägt.

Eine solche Plasmaquelle ist beispielsweise auch ein Elektronenoder Ionenquelle, die nach dem Penning-Quellen-Prinzip aufgebaut ist. Eine solche besteht aus zwei Kathoden mit dazwischen liegender Hohlanode. Die Achsen dieser drei Elektroden liegen häufig auf einer gemeinsamen Geraden, eine der Kathoden ist eine Hohlkathode, durch die hindurch Ladungsträger aus dem Plasma zwischen den Kathoden und durch die Hohlanode extrahiert werden. Die Hohlanode umgibt eine Einrichtung zur Erzeugung eines Magnetfelds, dessen Achse parallel zu den Elektodenachsen verläuft und das durch die Hohlanode geht. Eine nichtgepulste, stromstarke Ladungsträgerquelle mit Penning-Quellen-Aufbau ist in der FR 2 489 010 beschrieben. Die Besonderheit dort liegt in der seitlichen Versetzung der Anode derart, dass noch ein gerader lichter Durchgang von der Hohlkathode durch die Hohlanode entlang der Kathodenachse bestehen bleibt.

Bei bisherigen Lösungen wird das Trigger-Plasma durch eine Gleitentladung entlang einer Isolatoroberfläche erzeugt (siehe o. e. IEEE-Zitat), dabei wird Isolatormaterial verbraucht. Die Lebensdauer der Gleitentladungs-Plasmaquelle ist folglich begrenzt, zudem wird Isolatormaterial auf den umgebenden Oberflächen abgelagert, wodurch die Zündeigenschaft der Einrichtung verändert und die Beschichtung verunreinigt wird .

Der Erfindung liegt die Aufgabe zugrunde, ein Verfahren zum Betreiben einer Elektronenquelle zu entwickeln und eine Triggerplasmaquelle zur Durchführung des Verfahrens bereitzustellen, mit dem in einem Prozeßraum ein stromstarke, gepulste Elektronenstrahlen zur Beschichten in großem technischen Maßstab bereitgestellt werden.

Die Aufgabe wird durch ein Verfahren nach Anspruch 1 und mit einer Triggerplasmaquelle nach Anspruch 5 zur Durchführung des Verfahrens gelöst. In einem zylindrischen Hohlraum sind die Stirnseiten als Kathoden ausgebildet und miteinander elektrisch gekoppelt, so daß sie stets gleiches Potential haben. Zwischen beiden Kathoden befindet sich eine hohlzylindrische Anode, deren Achse mit der Achse des Hohlraums zusammenfällt. Der Hohlraum ist mit Gas gefüllt, wobei ein Druck derart aufrecht erhalten wird, daß sich durch lawinenartige Stoßionisation dort ein Plasma bildet. Durch geeignete elektrische Potentiale an den Elektroden wird mit Hilfe eines axial gerichteten Magnetfeldbereichs hinreichender Feldstärke im Elektrodenzwischenraum über Stoßionisation das Plasma erzeugt. Der Vorgang ist unter dem Begriff Penning-Entladung bekannt.

Eine der Kathoden ist als topfförmige Hohlkathode ausgebildet, die durch ihren Boden auf der Achse eine Emissionsbohrung hat. In dem Topfraum über der Emissionsöffnung beginnt ein dielektrisches Rohr, das im Prozeßraum endet. Nachdem der Zusammenbruch des Potentialunterschieds zwischen den Kathoden und der hohlzylindrischen Anode eingetreten ist, werden durch den dann einsetzenden Anodendurchgriff durch die Hohlkathode Elektronen in dem dielektrischen Rohr in den Prozeßraum abgesaugt, und zwar so lange, bis auch der Potentialunterschied zwischen den Kathoden und der Prozeßraumwand ausgeglichen ist. Diese Strahlausbildung wird als Kanalfunke bezeichnet. Danach kann der Ladeprozeß zur Potentialeinstellung an den Elektroden für die Plasmabildung erneut gestartet werden. Während dieser Einstellungs- oder Ladezeit rekombiniert auch das Gas in dem zylindrischen Hohlraum. Da der Prozeßraum ständig unter Vakuum gehalten wird, wird der vorgegebene Gasdruck im zylindrischen Hohlraum über ständig druckgeregeltes Nachströmen aufrechterhalten. Bei einem Prozeßraumdruck von 0,1 - 2 Pa ist jedoch eine Gasbeigabe für die Funktionsweise nicht zwingend erforderlich.

Die Unteransprüche 2 bis 4 kennzeichnen Verfahrensschritte, die das prinzipielle Verfahren nach Anspruch 1 vorteilhaft ergänzen. So kann die Wegverlängerung der Elektronen für den Stoßionisationsprozeß im zeitlich konstanten (Anspruch 2) als auch im zeitlich veränderlichen (Anspruch 3) Magnetfeld erfolgen. Im zylindrischen Hohlraum wird zur Plasmabildung mit hoher Ladungsträgerdichte eine Penning-Entladung durchgeführt (Anspruch 4).

Die Triggerplasmaquelle zur Durchführung des beschriebenen Verfahrens besteht aus (Anspruch 5): Plasmakammer - Prozeßraum, die beide über das dielektrische Rohr miteinander verbunden sind. Die Plasmakammer, in der das Triggerplasma ohne Gleitentladung erzeugt wird, ist außerhalb von einer Einrichtung zur Erzeugung des auf der Achse axial gerichteten Magnetfelds umgeben. Mit dieser Plasmaquelle wird eine hohe Plasmadichte erzeugt. Hierbei kommt der Anode und ihrer Positionierung im Entladungsraum wesentliche Bedeutung zu, und zwar ist für den Langzeitbetrieb entscheidend, daß die Plasmabildung stets gleitladungsfrei, also ohne einen Erosionsprozeß erfolgt. Deshalb wird die Anode über den durch die Wand gehenden Metallstift konzentrisch zur Kammerachse auf Abstand zur Kammerwand gehalten. Diese Maßnahme hat sich als wesentlich für eine gleichbleibende Qualität des Elektronenstrahls und damit für eine gute Langzeitkonstanz erwiesen.

Das Bauprinzip entspricht der prinzipiellen Elektrodenanordnung in einer Penning-Quelle. Ob der Magnet ein Permanetmagnet oder eine gleichstromdurchflossene Spule (Ansprüche 7 und 8) ist, bleibt sekundär. Eine einfache technische Lösung des Aufbaus der Trigger-Plasmaquelle besteht in der magnetfelderzeugenden Spule, die mit einem Kondensator zu einem LC-Schwingkreis verbunden ist (Anspruch 9) und durch einen steuerbaren Schalter unterbrochen werden kann, wobei der Schalter ein Halbleiterschalter (Anspruch 10) wie beispielsweise ein Thyristor ist. Andere Schalter kommen, solange sie schnell genug schaltbar sind und ausreichende Stromtragfähigkeit haben, genauso in Betracht.

Die Nutzung einer Penning-Entladung zur Erzeugung eines Elektronenstrahl, des Kanalfunkens, verbessert die Ablationswirkung desselben auf dem Target im Prozeßraum und erhöht die Lebensdauer der gesamten Triggerplasmaquelle um ein Vielfaches gegenüber Quellen, die das Triggerplasma mittels einer Gleitentladung entlang eines Opfermaterials erzeugen. Das zeigt sich auch konstruktiv, weil nämlich bei der Penning-Entladung und Kanalfunken-Erzeugung die gesamte Anordnung auf einer Achse, der Symmetrieachse, liegt. Die Triggerplasmaquelle verbessert die Strahltransmission des Elektronenstrahls meßbar damit, daß die Abnahme der pro Entladung ablatierten Targetmaterialmenge mit größer werdendem Abstand vom Kanalrohrende bis zum Target wesentlich geringer ist als bei bisherig bekannten Ansätzen. Weiter ist die Reproduzierbarkeit des Elektronenstrahls stark verbessert und damit die Streuung der ablatierten Materialmenge von Entladung zu Entladung geringer. Die entscheidende Maßnahme ist die gepulste Penning-Entladung als Plasmaquelle für den Kanalfunken im Selbstablaufbetrieb, d. h. mit der Ausbildung des Magnetfelds und der dadurch folgenden Plasmabildung läuft die Strahlentwicklung selbsttätig ab, so daß die Potentialentwicklung an den Elektroden nicht gesteuert werden muß.

Die Erfindung wird anhand des durchgeführten Aufbaus der Triggerplasmaquelle und der Zeichnung im folgenden beschrieben. Es zeigen:
Figur 1 die elektrisch beschaltete Triggerplasmaquelle,
Figur 2 den zeitlichen Verlauf von Strom und Spannung an der Quelle und
Figur 3 den zeitlichen Verlauf der Spannung an der Anode und der Hohlkathode während der Zündung der Kanalentladung.

Die Triggerplasmaquelle ist eine Penning-Quelle 1. Sie besteht aus der Elektrodenanordnung 2, 6, 7 un dem von der Hohlkathode 2 abgehenden dielektrischen Rohr 3, dem Kanalrohr, das in den Prozeßraum 4 mundet. Die Hohlkathode 2, das Keramikrohr 3 und der Eintritt in den Prozeßraum 4 bilden das Kanalfunkensystem. Der konstruktive Aufbau der Penning-Triggerplasmaquelle und des Kanalfunkensystems liegen auf der Achse 5 und sind rotationssymmetrisch dazu. Die Trigger-Plasmaquelle besteht aus den zwei einander gegenüberliegenden Kathoden 2, 6, der dazwischen liegenden hohlzylindrischen Anode 7 und dem dielektrischen Gehäuse 8, mit dem die Elektroden 2, 6, 7 in Position gehalten werden. Die Zuleitung zur Anode 7 ist der Stift 9, der in dieselbe eingeschraubt wird und stiftaxial verschieb- und feststellbar ist, so daß die Anode 7 auf Distanz zur Gehäuseinnenwand gehalten werden kann.

Die Triggerplasmaquelle wird gepulst betrieben und ist dazu entsprechend elektrisch beschaltet: Die beiden Kathoden 2, 6 sind elektrisch miteinander verbunden und befinden sich dadurch stets auf einem gemeinsamen Potential. Der Kondensator C_{H} verbindet die Hohlkathode 2 und die Anode 7, ebenso verbindet der andere Kondensator C_{E} die Hohlkathode 2 mit dem metallischen Bereich der Prozeßraumwand 14 um den Kanalrohreintritt. Die Anode 7 ist über den Widerstand R mit der Prozeßraumwand 14 verbunden. Wird die Holhkathode 2 an ein Konstantstromladegerät gelegt, stellt sich das für die Plasmazundung und die Elektronenstrahlentwicklung notwendige elektrische Anfangspotential von hier -20 kV an den Elektroden 2, 6, 7 ein. Im Durchführungsbeispiel liegt die Hohlkathode 2 ständig an dem Konstantstromladegerat, das mit einem zeitlinearen Strom auflädt.

Das Gehäuse 8 ist aus einer Keramik und vorteilhafterweise zur Feineinstellung der Elektrodenabstande bearbeitbar. Gleichzeitig bildet das Gehäuse 8 den Spulenkörper für die Magnetfeldspule 10, die hier gepulst mit einem sinusförmigen Strom betrieben wird. Hierzu ist sie mit dem internen Kondensator C_{I} im Triggergerät 11 zu einem LC-Serienschwingkreis geschaltet, der durch den Thyristor über den Impulsgenerator 13 mit einstellbarer Folgefrequenz unterbrochen wird. Im Ansteuergerät 11 ist noch die Ladeeinrichtung an den internen Kondensator C_{I} angeschlossen, mit dem dieser in den Strompulspausen wieder auf den einstellbaren Maximalwert aufgeladen wird.

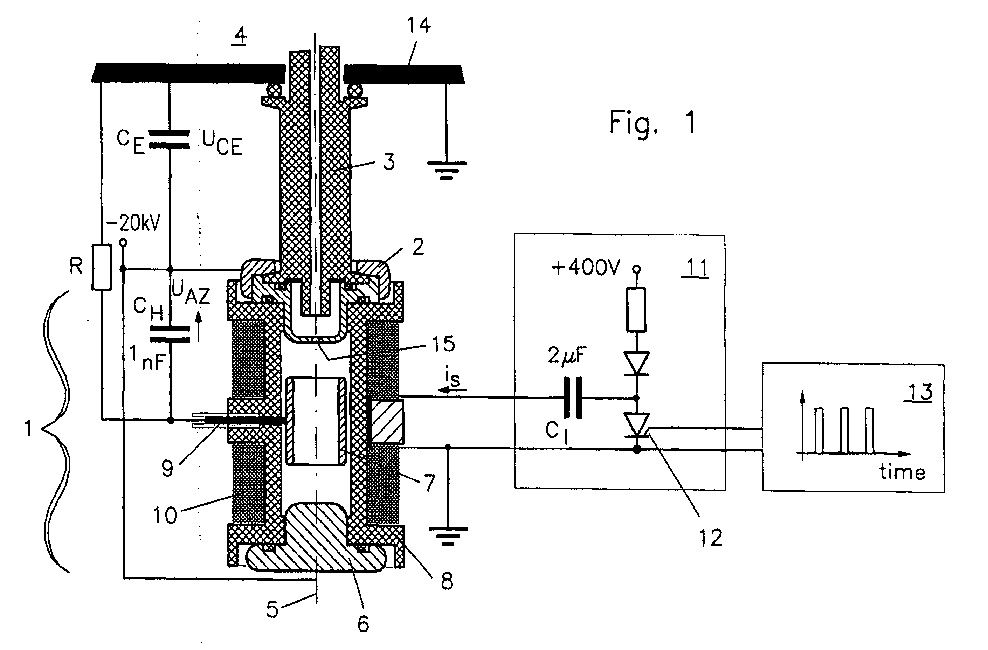

Der Gaseinlaß in das Penning-Rohr ist der Ubersicht halber in die Figur 1 nicht eingezeichnet, könnte aber unproblematisch z. B. wie der Stift 9 zur Anode 7 durch die Wand des Gehäuses 8 gelegt werden. Überhaupt ist eine Gaszuführung nur bei größerem Druckgradienten zwischen Penning-Rohr und Prozeßraum erforderlich.

Die Funktionsweise der Triggerplasmaquelle beruht darauf, daß sich elektrische Ladungsträger in einem axial gerichteten Magnetfeldbereich bewegen und dadurch zur Gyration gezwungen werden, wodurch die Weglänge erheblich verlängert wird. Dadurch halten die Ladungsträger sich länger im Entladungsvolumen der Triggerquelle auf und stoßen sehr viel wahrscheinlicher, so daß sich wegen des bestehenden Gasdrucks eine lawinenartige Stoßionisation mit Plasmabildung einstellen kann.

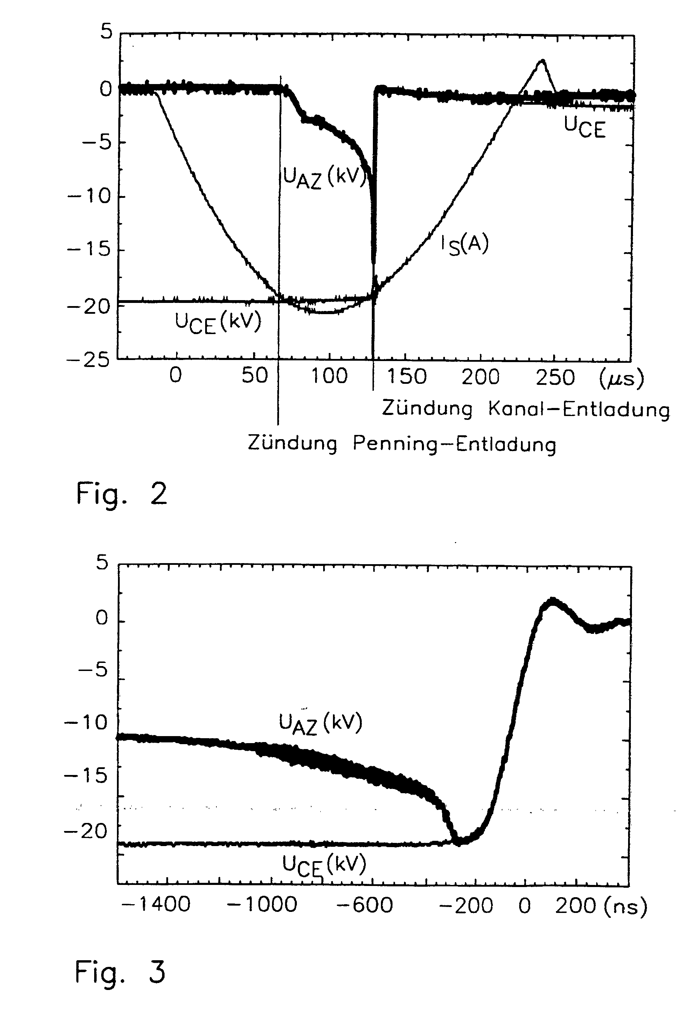

Der Zündvorgang der Penning-Triggerplasmaquellewird durch das Anlegen des Magnetfelds ausgelöst. Zunächst befinden sich die Hohlkathode 2 und die Gegenkathode 6 gegenüber dem statisch geerdeten Prozeßraum 14 auf vorgegeben negativem Potential, hier Uₒ = -20 kV. Die Anode 7 befindet sich über den Widerstand R zunächst auf Massepotential (Figur 2). Beide Kondensatoren sind über die Stromversorgung auf -20 kV aufgeladen.

Ohne Magnetfeld im Elektrodenhohlraum würde sich beim herrschenden Gasdruck keine Gasentladung ausbilden, weil die mittlere freie Weglänge der Elektronen größer als die Hohlraumgeometrie ist. Unter diesen Voraussetzungen kann keine Stoßionisation und damit auch keine Ladungsträgervermehrung mit schließlicher Plasmaerzeugung in der Penning-Röhre stattfinden. Durch Zünden des Thyristors und damit Schließen des LC-Serienschwingkreises wird in der Penning-Röhre das sinusförmig ansteigende, axial gerichtete Magnetfeld (Figur 2) erzeugt, das die Elektronen um die Achse 5 gyrieren läßt. Jetzt wird die Wegstrecke der Elektronen genügend lang, so daß Stoßionisation stattfindet. Die Ladungstragerdichte in der Penning-Röhre nimmt zu. Als Folge der zunehmenden Ladungsträgerdichte steigt der Strom in der Penning-Entladung, die Kapazität C_{H} wird entladen. Das Potential an der Anode 7 geht gegen das der beiden Kathoden 2, 6 (siehe Verlauf von U_{AZ}). Ist die Kapazität C_{H} vollständig entladen, besteht zwischen den Elektroden kein Potentialunterschied (U_{AZ} = U_{CE}) mehr, zu diesem Zeitpunkt herrscht in der Penning-Röhre ein Plasma mit hoher Dichte. Jetzt greift das elektrische Feld, das von dem noch geladenen Kondensator C_{E} erzeugt wird, von der Prozeßraumwand 14 her auf die Elektroden 2, 6, 7 über. Durch den Felddurchgriff durch die Hohlkathode 2 werden Elektronen in das dielektrische Rohr und durch es hindurch beschleunigt. Das ist der Kanalfunke, der so lange besteht, bis der Kondensator C_{E} durch diesen entladen ist (U_{CE} = 0). Aus Figur 3 ist die Lebensdauer von etwa 200 nsec als dem Zeitintervall des gemeinsamen, steilen Anstiegs von U_{AC} und U_{CE} zu entnehmen.

Die Dimensionierung der elektrischen Beschaltung ist im Durchführungsbeispiel so vorgenommen, daß nach Potentialeinstellung an der Penning-Röhre und anschließender Zündung des Thyristors 12 der Ablauf bis zur Ausbildung des Kanalfunkens selbstständig abläuft. Nach Erloschen des Kanalfunkens aufgrund der vollständigen Entladung des Kondensators C_{E} kann frühestens der nächste Ladezyklus zur Anfangspotentialeinstellung an den Elektroden 2, 6 und 7 beginnen.

Die Lebensdauer der Trigger-Plasmaquelle ist mit bislang 22 Millionen Entladungen noch nicht eingeschränkt. Wiederholfrequenzen von bis zu 70 Hz sind im Dauerbetrieb über Tage bisher ohne Ausfällse erreicht worden.

Mit herkömmlichen Gleitentladungstrigger liegt die ablatierte Glasmenge pro Kanalfunke bei etwa 1,5 - 2 µg, die Penning Trigger-Plasmaquelle mit Kanalfunkensystem ablatiert 6 - 8 µg pro Kanalfunke. Auch bleibt die wie bei der Gleitentladung vorgenommene Abstandsvariation: Kanalende - Target nahezu ohne Einfluß auf die ablatierte Glasmenge.

Große Reserven durch optimierte Bauteiledimensionierung bestehen. Eine einflußreiche technische Maßnahme ist die hohlzylindrische Anode auf Abstand zur Gehäuseinnenwand zu halten. Dadurch kann sich dort während des Langzeitbetriebs entlang der Gehäusewand keine parasitäre Gleitentladungen einrichten. Der Selbstablauf der Potentialentwicklung an den Elektroden mit dem Anlegen des Magnetfelds zur Plasmazündung läßt einen einfachen technischen Aufbau zu, da keine zusätzliche Steuerung eingerichtet werden muß.

### Bezugszeichenliste

- 1: Penning-Quelle, Triggerplasmaquelle
- 2: Hohlkathode
- 3: dielektrisches Rohr, Isolierrohr, Kanal
- 4: Prozeßraum
- 5: Achse
- 6: Kathode
- 7: Anode
- 8: dielektrisches Gehäuse, Hohlkörper
- 9: Stift
- 10: Magnetfelderzeugungseinrichtung, Permanentmagnet, Spule
- 11: Ansteuergerät
- 12: Schalter, Thyristor
- 13: Impulsgenerator
- 14: Wand, Prozeßraumwand
- 15: Emissionsbohrung

## Patentansprüche

1. Verfahren zur Erzeugung eines gepulsten Elektronenstrahls, bestehend aus den Schritten:
- in einem, zwischen zwei auf einer Achse (5) liegenden Kathoden (2, 6), axial ausgerichteten Magnetfeldbereich, zu dessen Achse (5) sich zwischen den zwei Kathoden (2, 6) eine hohlzylindrische Anode (7) befindet, wird über Stoßionisation ein Plasma erzeugt,
**gekennzeichnet durch** die Schritte:
- die Elektroden (2, 6, 7) werden über einen zylindrischen Hohlkörper (8) aus dielektrischem Material in Position gehalten und in dem **dadurch** gebildeten Hohlraum wird ein vorgegebener Gasdruck von etwa 0,1 - 2 Pa zur Plasmaausbildung unter Vermeidung von Selbstzündung aufrechterhalten,
- nach provoziertem Zusammenbruch des Potentialunterschieds zwischen der Anode (7) und den stets auf gleichem Potential liegenden Kathoden (2, 6) werden Elektronen über eine der Kathoden (2, 6), die als Hohlkathode (2) mit Emissionsbohrung (15) ausgebildet ist, in einem dielektrischen Rohr (3), das sich zwischen der Hohlkathode (2) und einem Prozeßraum (4) befindet, in einem ab dem Zusammenbruch von der Bewandung des Prozeßraums (4) **durch** die Emissionsbohrung (15) der Hohlkathode (2) greifenden elektrischen Feld als gebündelter Strahlpuls, Kanalfunke, abgezogen und auf ein Target vorbestimmten Materials gerichtet,
- die zeitliche Länge des Elektronenstrahlpulses wird von dem Abbau des Potentialunterschieds zwischen der Prozeßraumbewandung (14) und der Hohlkathode (2) bestimmt,
- frühestens nach dem Erreichen der Potentialgleichheit von Prozeßraumbewandung (14) und Hohlkathode (2) wird begonnen, die für die Erzeugung des Plasmas notwendigen Anfangspotentiale über ein Ladegerät erneut einzustellen.

2. Verfahren nach Anspruch 1,
**dadurch gekennzeichnet, daß**
das Magnetfeld mit dem axial ausgerichteten Magnetfeldbereich über einen Permanentmagneten (10) oder eine gleichstromdurchflossene Spule (10) erzeugt wird.

3. Verfahren nach Anspruch 1, **dadurch gekennzeichnet, daß**
das Magnetfeld mit dem axial ausgerichteten Magnetfeldbereich über eine stromdurchflossene Spule (10) erzeugt wird, wobei der Strom zeitlich veränderlich ist, so daß die für die Plasmazündung notwendige Feldstärke im Elektrodenzwischenraum lediglich temporär erreicht wird.

4. Verfahren nach Anspruch 3,
**dadurch gekennzeichnet, daß** im Zwischenraum der Elektroden (2, 6, 7) eine Penning-Entladung hoher Plasmadichte erzeugt wird, aus der der Elektronenstrahl abgesaugt wird.

5. Triggerplasmaquelle zur Durchführung des Verfahrens nach den Ansprüchen 1 bis 4, bestehend aus:
- einer Elektrodenanordnung (2, 6, 7) von zwei Kathoden (2, 6) und einer dazwischen liegenden hohlzylindrischen Anode (7), deren Achsen parallel zueinander stehen,
- einer Magnetfeld-Erzeugungseinrichtung (10) um die Anode (7), deren Magnetfeldachse parallel zu den Elektrodenachsen ist,
**dadurch gekennzeichnet, dass**:
- ein zylindrischer Hohlkörper (8) aus dielektrischem Material die Elektroden (2, 6, 7) in Position hält,
- die Magnetfeld-Erzeugungseinrichtung (10) koaxial um die Anode (7) sitzt und sich bis über den jeweiligen Stirnbereich der beiden Kathoden (2, 6) hinaus erstreckt,
- einem dielektrischen Rohr (3), das in der Nähe einer Emissionsbohrung (15) von einer der beiden Kathoden (2, 6), die als Hohlkathode (2) ausgebildet ist, ausgeht und in einem Prozeßraum (4) endet, wobei die Bewandung desselben zumindest in der Umgebung des durchdringenden dielektrischen Rohrs (3) metallisch ist,
- einer kapazitiv-resistiven Beschaltung der drei Elektroden (2, 6, 7) und dem metallischen Bereich der Wand des Prozeßraums, zur Einrichtung der Potentialbedingungen für die Plasmaerzeugung und Absaugung des Strahlpulses aus elektrisch geladenen Teilchen durch das dielektrische Rohr (3),
- der hohlzylindrischen Anode (7), die über einen Metallstift (9), der senkrecht zur Achse (5) durch die Wand des zylindrischen Hohlkörpers (8) aus dielektrischem Material führt, derart in Position gehalten wird, daß zwischen ihr und der Hohlrauminnenwand ein vorgegebener Abstand besteht.

6. Triggerplasmaquelle nach Anspruch 5,
**dadurch gekennzeichnet, daß**
die rotationssymmetrische Elektrodenanordnung aus den beiden Kathoden (2, 6), der hohlzylindrischen Anode (7) und dem positionierenden Hohlkörper (8) sowie der Magnetfeld-Erzeugungseinrichtung (10) eine Penning-Plasmaquelle (1) ist.

7. Triggerplasmaquelle nach Anspruch 6,
**dadurch gekennzeichnet, daß**
die Magnetfelderzeugungseinrichtung (10) ein Permanentmagnet und/oder eine stromdurchflossene Spule ist.

8. Triggerplasmaquelle nach Anspruch 7,
**dadurch gekennzeichnet, daß**
die Magnetfelderzeugungseinrichtung (10) eine Spule ist, die über ein Ansteuergerät mit einem Strom vorgegebenen zeitlichen Verlaufs gespeist wird.

9. Triggerplasmaquelle nach Anspruch 8,
**dadurch gekennzeichnet, daß**
das Ansteuergerät aus einer Ladeeinrichtung zum Laden eines Kondensators C_{T} besteht, der mit der Spule (10) und einem steuerbaren Schalter (12) einen unterbrechbaren LC-Schwingkreis bildet.

10. Triggerplasmaquelle nach Anspruch 9,
**dadurch gekennzeichnet, daß**
der steuerbare Schalter (12) ein Halbleiterschalte ist, der von einem Impulsgenerator (13) gesteuert wird.

11. Triggerplasmaquelle nach Anspruch 10,
**dadurch gekennzeichnet, daß**
die Hohlkathode (2) topfförmig ausgebildet ist und das dielektrische Rohr (3) in den Topfbereich bis nahe an die Emissionsbohrung (15) auf der Achse (5) hineinragt.

## Claims

1. Method for generating a pulsed electron beam, comprising the steps:
- a plasma is generated through ionisation by impact in an axially orientated magnetic field region between two cathodes (2, 6), which are situated on one axis (5), a hollow cylindrical anode (7) being situated between the two cathodes (2, 6) at the axis (5) of said magnetic field region,
**characterised by** the steps:
- the electrodes (2, 6, 7) are held in position via a cylindrical hollow body (8) made from dielectric material and in the hollow space thus formed a predetermined gas pressure of approximately 0.1 - 2 Pa is maintained for the developing of plasma whilst avoiding spontaneous ignition,
- after provoked degradation of the potential difference between the anode (7) and the cathodes (2, 6), which always have the same potential, electrons are drawn off in the form of bundled beam pulse, duct spark, via one of the cathodes (2, 6), which is in the form of a hollow cathode (2) with emission bore (15), in a dielectric pipe (3), which is situated between the hollow cathode (2) and a process chamber (4), in an electric field, which, from the degradation, extends from the wall of the process chamber (4) through the emission bore (15) of the hollow cathode (2), and are orientated onto a target of predetermined materials,
- the time length of the electron beam pulse is determined by the degradation of the potential difference between the process chamber wall (14) and the hollow cathode (2),
- a start is not made on adjusting the initial potential necessary for the generation of the plasma once again via a charging device until the potential equality is achieved between process chamber wall (14) and hollow cathode (2).

2. Method according to claim 1, **characterised in that** the magnetic field with the axially orientated magnetic field region is generated via a permanent magnet (10) or a coil (10) traversed by direct current.

3. Method according to claim 1, **characterised in that** the magnetic field with the axially orientated magnetic field region is generated via a current-carrying coil (10), wherein the current is changeable in time, such that the field strength necessary for the plasma ignition is achieved in the electrode intermediate chamber simply in a temporary manner.

4. Method according to claim 3, **characterised in that** in the intermediate chamber of the electrodes (2, 6, 7) a Penning discharge of high plasma density is generated, from which the electron beam is drawn off.

5. Trigger plasma source for the accomplishment of the method according to claims 1 to 4, comprising:
- an electrode arrangement (2, 6, 7) of two cathodes (2, 6) and one hollow cylindrical anode (7) situated in between, the axes of which are parallel relative to each other,
- a magnetic field generating device (10) around the anode (7), the magnetic field axis of which is parallel to the electrode axes,
**characterised in that**:
- a cylindrical hollow body (8) made of dielectric material holds the electrodes (2, 6, 7) in position,
- the magnetic field generating device (10) sits coaxially around the anode (7) and extends beyond the respective front region of the two cathodes (2, 6),
- a dielectric pipe (3), which starts in the vicinity of an emission bore (15) from one of the two cathodes (2, 6), which is in the form of hollow cathode (2), and terminates in a process chamber (4), wherein the wall of this latter is metallic at least in the surroundings of the penetrating dielectric pipe (3),
- a capacitive-resistive circuit between the three electrodes (2, 6, 7) and the metallic region of the wall of the process chamber, for setting up the potential conditions for the plasma generating and the extracting of the beam pulse from electrically charged particles through the dielectric pipe (3),
- the hollow cylindrical anode (7), which is held in position by a metal pin (9), which runs at right angles to the axis (5) through the wall of the cylindrical hollow body (8) made of dielectric material, in such a manner that there is a predetermined distance between said anode (7) and the internal wall of the hollow chamber.

6. Trigger plasma source according to claim 5, **characterised in that** the rotationally symmetrical electrode arrangement made from the two cathodes (2, 6), the hollow cylindrical anode (7) and the positioning hollow body (8) as well the magnetic field generating device (10) is a Penning plasma source (1).

7. Trigger plasma source according to claim 6, **characterised in that** the magnetic field generating device (10) is a permanent magnet and/or a current-carrying coil.

8. Trigger plasma source according to claim 7, **characterised in that** the magnetic field generating device (10) is a coil, which is supplied with a current of predetermined time behaviour via a drive device.

9. Trigger plasma source according to claim 8, **characterised in that** the drive device comprises a charging device for charging a capacitor C_{T}, which forms an interruptible LC oscillating circuit with the coil (10) and a controllable switch (12).

10. Trigger plasma source according to claim 9, **characterised in that** the controllable switch (12) is a semiconductor switch, which is controlled by a pulse generator (13).

11. Trigger plasma source according to claim 10, **characterised in that** the hollow cathode (2) is cup-shaped and the dielectric pipe (3) extends into the cup region as far as almost the emission bore (15) on the axis (5).

## Revendications

1. Procédé de génération d'un faisceau d'électrons pulsé, composé des étapes suivantes :
- un plasma est généré par ionisation par impact dans une zone de champ magnétique orientée axialement entre deux cathodes (2, 6) présentes sur un axe (5), une anode (7) cylindrique creuse se trouvant sur l'axe (5) entre les deux cathodes (2, 6),
**caractérisé par**
les étapes suivantes :
- les électrodes (2, 6, 7) sont maintenues en position par le biais d'un corps creux cylindrique (8) constitué d'un matériau diélectrique et une pression de gaz prédéterminée, égale à environ 0,1 à 2 Pa, est maintenue dans la chambre creuse ainsi formée pour la formation d'un plasma en évitant un auto-amorçage,
- après une abolition provoquée de la différence de potentiel entre l'anode (7) et les cathodes (2, 6), qui se trouvent constamment au même potentiel, les électrons sont attirés sous forme d'impulsion de faisceau focalisée, c'est-à-dire d'étincelle de canal, par le biais de l'une des cathodes (2, 6), qui est configurée sous forme de cathode creuse (2) dotée d'un orifice d'émission (15), dans un tube diélectrique (3), qui se trouve entre la cathode creuse (2) et une chambre de processus (4), dans un champ électrique s'étendant, après l'abolition de la différence de potentiel, de la paroi de la chambre de processus (4) à travers l'orifice d'émission (15) de la cathode creuse (2), puis sont dirigés sur une cible constituée d'un matériau prédéterminé,
- la longueur en temps de l'impulsion de faisceau d'électrons est déterminée par l'abolition de la différence de potentiel entre la paroi (14) de la chambre de processus et la cathode creuse (2),
- au plus tôt après l'obtention de l'égalité de potentiel entre la paroi (14) de la chambre de processus et la cathode creuse (2), on commence à régler de nouveau, par le biais d'un chargeur, les potentiels initiaux nécessaires à la génération du plasma.

2. Procédé selon la revendication 1,
**caractérisé en ce que**
le champ magnétique comportant la zone de champ magnétique orientée axialement est généré par un aimant permanent (10) ou d'une bobine traversée par un courant continu (10).

3. Procédé selon la revendication 1,
**caractérisé en ce que**
le champ magnétique comportant la zone de champ magnétique orientée axialement est généré par une bobine traversée par un courant (10), ce courant étant variable dans le temps, de telle sorte que l'intensité de champ nécessaire à l'amorçage du plasma dans l'espace intermédiaire entre les électrodes est seulement temporairement atteinte.

4. Procédé selon la revendication 3,
**caractérisé en ce que**
dans l'espace intermédiaire entre les électrodes (2, 6, 7) est générée une décharge Penning de haute densité de plasma, à partir de laquelle est aspiré le faisceau d'électrons.

5. Source de plasma d'excitation permettant de mettre en oeuvre le procédé selon les revendications 1 à 4, composé de :
- un ensemble d'électrodes (2, 6, 7) constitué de deux cathodes (2, 6) et une anode cylindrique creuse (7) disposée entre celles-ci, dont les axes sont parallèles les uns aux autres,
- un dispositif de génération de champ magnétique (10) disposé autour de l'anode (7), dont l'axe de champ magnétique est parallèle à l'axe des électrodes,
**caractérisée en ce que**
- un corps creux cylindrique (8) constitué d'un matériau diélectrique maintient les électrodes (2, 6, 7) en position,
- le dispositif de génération de champ magnétique (10) est disposé de façon coaxiale autour de l'anode (7) et s'étend jusqu'à la zone frontale respective des deux cathodes (2, 6),
- un tube diélectrique (3), qui commence à proximité d'un orifice d'émission (15) de l'une des deux cathodes (2, 6) configurée sous forme de cathode creuse (2) et qui débouche dans une chambre de processus (4), la paroi de celle-ci étant métallique au moins dans l'entourage du tube diélectrique traversant (3),
- une mise en circuit capacitive-résistive des trois électrodes (2, 6, 7) et de la zone métallique de la paroi de la chambre de processus, afin d'établir les conditions de potentiel pour la génération du plasma et pour l'aspiration de l'impulsion de faisceau à partir des particules chargées électriquement à travers le tube diélectrique (3),
- l'anode cylindrique creuse (7), qui est maintenue en position par le biais d'une tige métallique (9) conduisant perpendiculairement à l'axe (5) à travers la paroi du corps creux cylindrique (8) constitué d'un matériau diélectrique, de telle sorte qu'il reste une distance prédéterminée entre celle-ci et la paroi intérieure de la chambre creuse.

6. Source de plasma d'excitation selon la revendication 5,
**caractérisée en ce que**
l'ensemble d'électrodes symétrique à la rotation, constitué des deux cathodes (2, 6), de l'anode cylindrique creuse (7) et du corps creux (8) de positionnement, ainsi que du dispositif de génération de champ magnétique (10), est une source de plasma Penning (1).

7. Source de plasma d'excitation selon la revendication 6,
**caractérisée en ce que**
le dispositif de génération de champ magnétique (10) est un aimant permanent et/ou une bobine traversée par un courant.

8. Source de plasma d'excitation selon la revendication 7,
**caractérisée en ce que**
le dispositif de génération de champ magnétique (10) est une bobine qui est alimentée par un appareil de commande avec un courant ayant une évolution prédéterminée dans le temps.

9. Source de plasma d'excitation selon la revendication 8,
**caractérisée en ce que**
l'appareil de commande se compose d'un dispositif de charge permettant de charger un condensateur C_{T}, qui forme avec la bobine (10) et un commutateur (12) pouvant être commandé, un circuit oscillant LC.

10. Source de plasma d'excitation selon la revendication 9,
**caractérisée en ce que**
le commutateur (12) pouvant être commandé est un commutateur à semi-conducteurs, qui est commandé par un générateur d'impulsions (13).

11. Source de plasma d'excitation selon la revendication 10,
**caractérisée en ce que**
la cathode creuse (2) est configurée en forme de marmite et le tube diélectrique (3) s'étend dans la zone en forme de pot jusqu'à proximité de l'orifice d'émission (15), au niveau de l'axe (5).
